# EUROPÄISCHE PATENTANMELDUNG

(11) **EP 2 899 672 A1**
(43) Veröffentlichungstag der Anmeldung: **29.07.2015**
(21) Anmeldenummer: 15000102.2
(22) Anmeldetag: 16.01.2015
(51) Int. Cl.: G06K 19/077

(54) **Verfahren zur Herstellung eines Chipmoduls**

(30) Priorität: 28.01.2014 DE 102014001069
(71) Anmelder: Giesecke & Devrient GmbH, 81677 München (DE)
(72) Erfinder: Büttner, Bernhard, 82110 Germering (DE); Reinl, Markus, 81827 München (DE)

(57) **Zusammenfassung**

Die vorliegende Erfindung offenbart ein Verfahren zur Herstellung eines Chipmoduls 2, wobei das Chipmodul 2 aus einem Trägersubstrat 4 und einem Gehäuse 6, in dem mindestens ein Chip 8 angeordnet wird, hergestellt wird, wobei das Gehäuse 6 auf dem Trägersubstrat 4 angeordnet wird, wobei mindestens ein Kontakt des Chips 8 eine elektrisch leitende Verbindung mit mindestens einem Kontakt auf einer Innenseite des Gehäuses 8 hat, wobei der mindestens eine Kontakt auf der Innenseite des Gehäuses 8 eine elektrisch leitende Verbindung mit mindestens einem Kontakt auf der Außenseite des Gehäuses 8 hat, wobei mindestens ein Kontakt auf der Außenseite des Gehäuses 8 mit mindestens einem Kontakt 16 auf dem Trägersubstrat 4 eine elektrisch leitende Verbindung bildet, wobei das Gehäuse 6 unabhängig vom Chip 8 eine einheitliche Anordnung von mindestens einem Kontakt auf der Außenseite aufweist, wobei das Trägersubstrat 4 eine einheitliche Anordnung von mindestens einem Kontakt 16 aufweist, wobei die Anordnung des mindestens einen Kontakts auf der Außenseite des Gehäuses 6 der Anordnung von mindestens einem Kontakt 16 auf dem Trägersubstrat 4 entspricht.

## Beschreibung

Die Erfindung beschreibt ein Verfahren zur Herstellung eines Chipmoduls, welches z.B. für die Herstellung von tragbaren Datenträgern mit Chipmodul, wie z.B. Chipkarten, Kreditkarten, SIM-Karten, Gesundheitskarten, Ausweisen, Führerscheinen verwendet wird.

Im Stand der Technik ist es bekannt, dass ein Chipmodul als sogenanntes Wirebond- oder als FCOS-Modul hergestellt wird. Die Miniaturisierung der Chips führt Herstellungsverfahren für Wirebond- oder FCOS-Module an technologische Grenzen. Dabei kompensieren die Vorteile einer Miniaturisierung der Chips die steigenden Herausforderungen und Probleme bei einer Herstellung eines Moduls.

Bei der Herstellung eines Wirebond-Moduls werden an einen Chip sogenannte Anschlussdrähte befestigt und anschließend wird das Ganze vergossen. Dies ergibt zwar ein mechanisch stabiles Modul, aber ein von der Bauhöhe vergleichsweises dickes Modul.

Beim Flip-Chip-Prozess, abgekürzt mit FCOS, wird ein Chip mit der Oberseite auf eine Rückseite eines Trägers geklebt und dann werden die Kontakte des Chips angeschlossen. Dieses Verfahren ergibt zwar vergleichsweise dünne Module, die aber mechanisch sehr empfindlich sind. Ferner muss die Anordnung der Kontakte auf dem Träger für jeden Chiptyp neu erstellt werden, da bei jedem Chiptyp die Kontaktflächen an einer anderen Stelle sind.

Ferner ist es aus logistischen Gründen notwendig, dass bereits gesägte Wafer eingelagert werden. Problematisch ist, dass gesägte Wafer in der Regel ein um den Faktor vier kürzeres garantiertes Mindesthaltbarkeitsdatum haben, als nicht gesägte Wafer. Der Grund ist, dass Wafer an sich nur für eine bestimmte Zeit verarbeitet werden können, da die Kontaktflächen auf dem Wafer korrodieren, was zu elektrischen Problemen führen kann. Um eine Korrosion zu vermeiden, müssen die Wafer unter definierten Klimabedingungen gelagert werden, was sehr aufwändig ist. Ein weiteres Problem ist, dass von einem Hersteller gelieferte Wafer in der Regel nur eine maximale Haltbarkeit von sechs Monaten garantiert wird, da die Wafer auf einer Folie aufgeklebt sind, welche nach einiger Zeit mit dem Wafer chemisch reagieren kann.

Ausgehend vom Stand der Technik ist es Aufgabe der Erfindung eine Lösung zu finden, welche die beschriebenen Nachteile vermeidet.

Die Aufgabe der Erfindung wird durch den unabhängigen Anspruch gelöst. Vorteilhafte Ausführungen sind in den abhängigen Ansprüchen beschrieben.

Zur Lösung der Aufgabe offenbart die Erfindung ein Verfahren zur Herstellung eines Chipmoduls, wobei das Chipmodul aus einem Trägersubstrat und einem Gehäuse, in dem mindestens ein Chip angeordnet wird, hergestellt wird, wobei das Gehäuse auf dem Trägersubstrat angeordnet wird, wobei mindestens ein Kontakt des Chips eine elektrisch leitende Verbindung mit mindestens einem Kontakt auf einer Innenseite des Gehäuses hat, wobei der mindestens eine Kontakt auf der Innenseite des Gehäuses eine elektrisch leitende Verbindung mit mindestens einem Kontakt auf der Außenseite des Gehäuses hat, wobei mindestens ein Kontakt auf der Außenseite des Gehäuses mit mindestens einem Kontakt auf dem Trägersubstrat eine elektrisch leitende Verbindung bildet, welches sich dadurch auszeichnet, dass das Gehäuse unabhängig vom Chip eine einheitliche Anordnung von mindestens einem Kontakt auf der Außenseite aufweist, wobei das Trägersubstrat eine einheitliche Anordnung von mindestens einem Kontakt aufweist, wobei die Anordnung des mindestens einen Kontakts auf der Außenseite des Gehäuses der Anordnung von mindestens einem Kontakt auf dem Trägersubstrat entspricht.

Vorteilhaft an dem erfindungsgemäßen Trägersubstrat ist, dass es ein dünnes Trägersubstrat ist, wie es z.B. auch für FCOS verwendet wird. Bei den Kontakten auf dem Trägersubstrat handelt es sich vorzugsweise um standardisierte Kontakte oder Anordnungen von Kontakten. Ferner weist das Trägersubstrat eine mechanische Stabilität auf, die das Trägersubstrat durch das Gehäuse, das auf dem Trägersubstrat befestigt ist, erhält.

Vorteilhaft ist auch, dass auf der Außenseite des Gehäuses standardisierte Kontakte angeordnet sein können, wobei es sich bei dem Gehäuse selbst um ein standardisiertes Gehäuse handeln kann. Das Gehäuse kann z.B. ein Quad Flat No Leads Package (QFN) sein.

Der große Vorteil der vorliegenden Erfindung ist, dass zur Herstellung eines Chipmoduls standardisierte Produkte, d.h. ein Trägersubstrat mit z.B. standardisierten Kontakten, und ein Gehäuse, das z.B. eine standardisierte Größe und z.B. standardisierte Kontakt aufweist, verwendet werden. Somit können auch Unternehmen, die sonst nur mit elektronischen Bauteilen bestückte Leiterplatten herstellen, auch Chipmodule herstellen, wobei früher nur speziell ausgerüstete Unternehmen in der Lage waren auch Chipmodule herzustellen.

Darüber hinaus muss nur noch ein einziger Typ eines Trägersubstrats bevorratet werden.

Die Chips können bereits in das Gehäuse eingebracht und anschließend gelagert werden, ohne, dass dabei ein Mindesthaltbarkeitsdatum beachtet werden muss, da die Chips im Gehäuse vergossen sind und somit eine Korrosion ausgeschlossen ist.

Ein vorteilhaftes Ausführungsbeispiel ist, dass mindestens ein Kontakt des Chips mit mindestens einem Kontakt auf der Innenseite des Gehäuses mittels eines Bonddrahts verbunden wird.

Ein weiteres vorteilhaftes Ausführungsbeispiel ist, dass der Chip im Gehäuse mittels einer Vergussmasse, z.B. einem Harz oder einem Kunststoff vergossen wird.

Ein weiteres vorteilhaftes Ausführungsbeispiel ist, dass das Gehäuse mittels eines Klebstoffs mit dem Trägersubstrat verbunden wird.

Ein weiteres vorteilhaftes Ausführungsbeispiel ist, dass auf den mindestens einen Kontakt auf der Außenseite des Gehäuses ein metallischer Höcker, ein sogenannter bump, aufgebracht wird, um eine elektrisch leitende Verbindung mit mindestens einem Kontakt des Trägersubstrats herzustellen.

Ein weiteres vorteilhaftes Ausführungsbeispiel ist, dass mindestens ein Kontakt auf der Außenseite des Gehäuses mit mindestens einem Kontakt des Trägersubstrats verlötet wird.

Ferner werden die oben genannten Probleme durch ein Chipmodul gelöst, welches gemäß den vorher beschriebenen Verfahrensschritten hergestellt wird.

Im Folgenden wird ein prinzipielles Ausführungsbeispiel der Erfindung anhand der beigefügten Figur beschrieben.

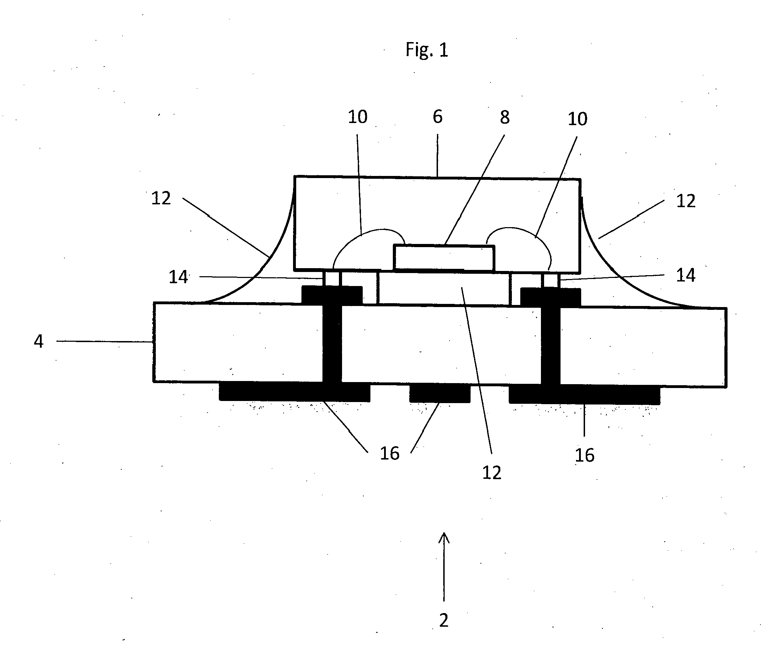

Figur 1 zeigt die prinzipielle Struktur eines erfindungsgemäß aufgebauten Chipmoduls 2.

Das Chipmodul 2 besteht aus einem Trägersubstrat 4 und einem Gehäuse 6. Im Gehäuse 6 ist ein Chip 8 angeordnet, z.B. fest geklebt. Das Gehäuse 6 ist z.B. ein Quad Flat No Leads Package, abgekürzt QFN. Der Chip 8 weist hier nicht dargestellte Kontakte auf, die mittels eines Bonddrahts 10 mit nicht dargestellten Kontakten auf der Innenseite des Gehäuses 6 elektrisch leitend verbunden sind. Das Gehäuse 6 ist vorzugsweise ausgegossen mit z.B. einem Harz oder einem Kunststoff, so dass der Chip 8 nicht korrodieren kann. Das Gehäuse 6 ist z.B. mittels Klebstoff 12 mit dem Trägersubstrat 4 dauerhaft verbunden. Das Gehäuse 6 verleiht dem Trägersubstrat 4 somit eine mechanische Festigkeit bzw. stabilisiert das Trägersubstrat 4. Die auf der Innenseite des Gehäuses 6 nicht dargestellten Kontakte sind elektrisch leitend mit auf der Außenseite des Gehäuses angeordnete, nicht dargestellte Kontakte verbunden. Auf die auf der Außenseite des Gehäuses 6 angeordneten Kontakte sind metallische Höcker, sogenannte Bumps 14 angeordnet. Die Aufgabe der Bumps 14 ist es eine elektrisch leitende Verbindung mit Kontaktflächen 16 herzustellen, die auf dem Trägersubstrat 4 angeordnet sind. Alternativ zu den Bumps 14 kann auch eine Lötverbindung verwendet werden. Die Lötverbindung kann die Funktion einer mechanischen Befestigung des Gehäuses 6 auf dem Trägersubstrat 4 übernehmen, so dass auf den Klebstoff 12 verzichtet werden kann. Die auf der Außenseite des Gehäuses 6 angeordneten Kontakte und die Kontakte 16 auf dem Trägersubstrat 4 sind jeweils zueinander einheitlich angeordnet, unabhängig davon welcher Chip 8 verwendet wird, so dass entsprechende Kontakte jeweils gegenüberliegen.

Das Trägersubstrat 4 kann in einem Rolle-zu-Rolle-Verfahren verarbeitet werden. Ferner kann auch das Gehäuse 6 mit Chip 8 in einem Rolle-zu-Rolle-Verfahren verarbeitet werden.

### Bezugszeichenliste

- 2: erfindungsgemäßes Chipmodul
- 4: Trägersubstrat
- 6: Gehäuse
- 8: Chip
- 10: Bonddraht
- 12: Klebstoff
- 14: Bump
- 16: Kontaktflächen auf Trägersubstrat

## Patentansprüche

1. Verfahren zur Herstellung eines Chipmoduls (2),
wobei das Chipmodul (2) aus einem Trägersubstrat (4) und einem Gehäuse (6), in dem mindestens ein Chip (8) angeordnet wird, hergestellt wird,
wobei das Gehäuse (6) auf dem Trägersubstrat (4) angeordnet wird,
wobei mindestens ein Kontakt des Chips (8) eine elektrisch leitende Verbindung mit mindestens einem Kontakt auf einer Innenseite des Gehäuses (8) hat,
wobei der mindestens eine Kontakt auf der Innenseite des Gehäuses (8) eine elektrisch leitende Verbindung mit mindestens einem Kontakt auf der Außenseite des Gehäuses (8) hat,
wobei mindestens ein Kontakt auf der Außenseite des Gehäuses (8) mit mindestens einem Kontakt (16) auf dem Trägersubstrat (4) eine elektrisch leitende Verbindung bildet,
**dadurch gekennzeichnet, dass**
das Gehäuse (6) unabhängig vom Chip (8) eine einheitliche Anordnung von mindestens einem Kontakt auf der Außenseite aufweist,
wobei das Trägersubstrat (4) eine einheitliche Anordnung von mindestens einem Kontakt (16) aufweist,
wobei die Anordnung des mindestens einen Kontakts auf der Außenseite des Gehäuses (6) der Anordnung von mindestens einem Kontakt (16) auf dem Trägersubstrat (4) entspricht.

2. Verfahren nach Anspruch 1, **dadurch gekennzeichnet, dass** mindestens ein Kontakt des Chips (8) mit mindestens einem Kontakt auf der Innenseite des Gehäuses (6) mittels eines Bonddrahts (10) verbunden wird.

3. Verfahren nach Anspruch 1 oder 2, **dadurch gekennzeichnet, dass** der Chip (8) im Gehäuse (6) mittels einer Vergussmasse vergossen wird.

4. Verfahren nach einem der Ansprüche 1 bis 3, **dadurch gekennzeichnet, dass** das Gehäuse (6) mittels eines Klebstoffs (12) mit dem Trägersubstrat (4) verbunden wird.

5. Verfahren nach einem der Ansprüche 1 bis 4, **dadurch gekennzeichnet, dass** auf den mindestens einen Kontakt auf der Außenseite des Gehäuses (6) ein metallischer Höcker (14) aufgebracht wird, um eine elektrisch leitende Verbindung mit mindestens einem Kontakt (16) des Trägersubstrats (16) herzustellen.

6. Verfahren nach einem der Ansprüche 1 bis 5, **dadurch gekennzeichnet, dass** mindestens ein Kontakt auf der Außenseite des Gehäuses (6) mit mindestens einem Kontakt (16) des Trägersubstrats (4) verlötet wird.

7. Chipmodul (2), welches gemäß dem Verfahren der Ansprüche 1 bis 6 hergestellt wird.
